(19) **Europäisches Patentamt**

**European Patent Office**

**Office européen des brevets**

(11) **EP 0 977 053 B1**

(12) **EUROPEAN PATENT SPECIFICATION**

(45) Date of publication and mention
of the grant of the patent:
**02.10.2002 Bulletin 2002/40**

(51) Int Cl.⁷: **G01S 13/89**, G01S 7/02,
G01S 13/90, G01R 23/163

(21) Application number: **99203843.0**

(22) Date of filing: **12.01.1995**

(54) **Non-contact type wave signal observation apparatus**

Berührungslose Beobachtungsvorrichtung von Wellensignalen

Appareil d'observation d'un signal sans contact

(84) Designated Contracting States:
**DE FR GB NL SE**

(30) Priority: **12.01.1994 JP 157494**
**12.01.1994 JP 157594**
**13.01.1994 JP 190494**
**19.01.1994 JP 410794**
**21.01.1994 JP 540294**

(43) Date of publication of application:
**02.02.2000 Bulletin 2000/05**

(62) Document number(s) of the earlier application(s) in
accordance with Art. 76 EPC:
**95400057.6 / 0 667 538**

(73) Proprietor: **Advantest Corporation**
**Nerima-ku, Tokyo 179-0071 (JP)**

(72) Inventor: **Kitayoshi, Hitoshi**
**Tokyo (JP)**

(74) Representative: **Joly, Jean-Jacques et al**
**Cabinet Beau de Loménie**
**158, rue de l'Université**
**75340 Paris Cédex 07 (FR)**

(56) References cited:
**EP-A- 0 408 112**       **US-A- 3 685 051**

**Description**

The invention relates to non-contact type wave signal observation apparatus. More particularly, the invention relates to a holographic radar. This holographic radar radiates electromagnetic waves into a space and, at a plurality of observation points in an observation plane, receives waves formed of an interference pattern of waves reflected from objects in the irradiated space. The holographic radar performs holographic reconstruction calculations on the interference waves and from the results of these calculations it detects the reflecting objects.

BACKGROUND OF THE INVENTION

There shall first be described the prior art relating to the present invention.

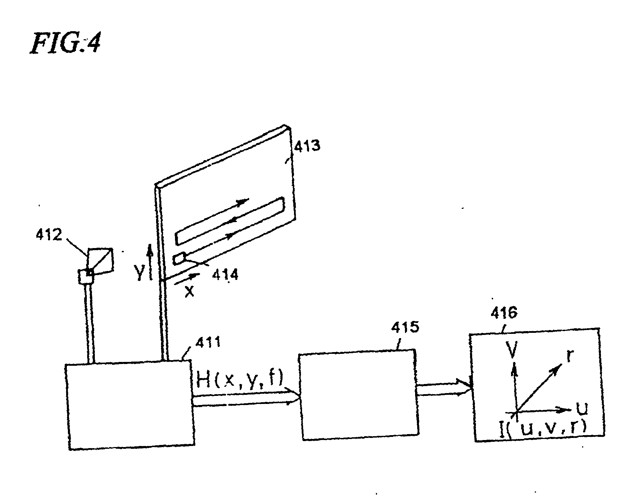

Fig.4 shows a prior art holographic radar. In this prior art holographic radar, high frequency signals, such as signals in the microwave and millimeter wave region, are supplied from a network analyzer 411 to an antenna 412 for illuminating a space with electromagnetic radiation. Antenna 412 continuously illuminates the observation space with electromagnetic radiation. Reflected waves from two or more locations in the observation space interfere and the interference is detected by a receive antenna 414 provided in a hologram observation plane 413 set up to view the space. Signals corresponding to the respective interference waves received at a plurality of points (x,y) in the hologram observation plane 413 are input to the network analyzer 411. The network analyzer 411 calculates transfer functions H(x,y,f) corresponding to the electromagnetic wave path from antenna 412 to observation point (x,y) in the hologram observation plane 413.

In the prior art holographic radar, receive antenna 414 is moved to each observation point (x,y) in turn on the observation plane 413 so as to receive reflected waves successively at each observation point (x,y). Alternatively, an array of antennas 414 was used, each antenna being positioned at one of the observation points (x,y) on the observation plane 413. In the latter case, each antenna of the array in turn is activated. Thus, in both cases, the reflected waves were received at a plurality of points (x,y) in the observation plane using scanning-antenna receiving means.

In this prior art system, the frequency, f, illuminating the space is changed in small steps and the space transfer function H(x,y,f) of each of the illuminating frequencies is measured as explained above. The transfer functions H(x,y, f) thus obtained are transformed by a hologram reconstruction calculation unit 415 performing hologram reconstruction calculations according to the following equation:

$$I(u,v,r) = \int \int \int H(x,y,f) \exp \{-j2\pi (ux + vy - fr)\} dx \, dy \, df \qquad (1)$$

where u and v are an azimuth angle and an elevation angle, respectively, when the observation space is viewed from the observation plane 413, and r is a distance from the observation plane.

Hologram reconstruction results I(u,v,r) are supplied to three-dimensional display unit 416 and are displayed so as to provide information regarding all three dimensions. For instance, I(u,v,r) is displayed in two dimensions (u,v) for a particular value of the distance r. Next, I(u,v,r) is displayed in two dimensions for a changed value of r, and so on.

In this prior art system, hologram reconstruction calculations were performed according to the above equation and thus, because of the required calculation of a triple integral, a very large number of individual calculations was necessary.

SUMMARY OF THE INVENTION

The present invention provides a holographic radar in which the radiated high frequency signal is modulated by a pulsed signal.

In one preferred embodiment of holographic radar according to the invention, (the subject of claim 1), the reflected signal is received by scanning-antenna receiving means and is quadrature detected. The quadrature detection output is sampled in synchronism with the pulsed signal used to modulate the illuminating high frequency signal, the precise timing of the sampling being controlled by a delay means implementing a variable delay td. Hologram reconstruction calculations of the observation plane are performed on the sampled signal. The results are displayed, together with the applicable value of the delay td, in three dimensions.

In a further preferred embodiment of holographic radar according to the invention, (the subject of claim 2), the reflected signal is received by scanning-antenna receiving means and is then converted to a signal of lower frequency synchronized with the pulsed signal used to modulate the illuminating high frequency signal. The converted signal is sampled at a frequency which is twice or more than twice that of the low frequency converted signal. Successive blocks of n samples are then subjected to respective discrete Fourier transforms. Hologram reconstruction calculations of the observation plane are performed on each of the sets of Fourier transform results corresponding to a respective transformed block of samples. The results and the delay value are synthesized and displayed in three dimensions.

BRIEF DESCRIPTION OF THE DRAWINGS

Fig.1 is a block diagram showing a first preferred embodiment of a holographic radar according to the invention.
Fig.2 is a block diagram showing a second preferred embodiment of a holographic radar according to the invention.
Fig.3 is a flowchart of an example of processing performed in the embodiment of Fig.1.
Fig.4 is a block diagram showing a prior art holographic radar.
Fig.5 is a block diagram showing an embodiment of a complex wave interference information display apparatus which may be used to display data obtained by the holographic radar apparatus according to the invention.
Fig.6 shows an example of results displayed using the apparatus of Fig.5.
Fig.7 is a block diagram showing two-dimensional interference data observation means (here, a holographic radar) useable to furnish data for display by the display apparatus of Fig.5.
Fig.8 is a block diagram showing further complex wave interference information observation means useable to furnish data for display by the display apparatus according to Fig.5.

DESCRIPTION OF THE PREFERRED EMBODIMENTS

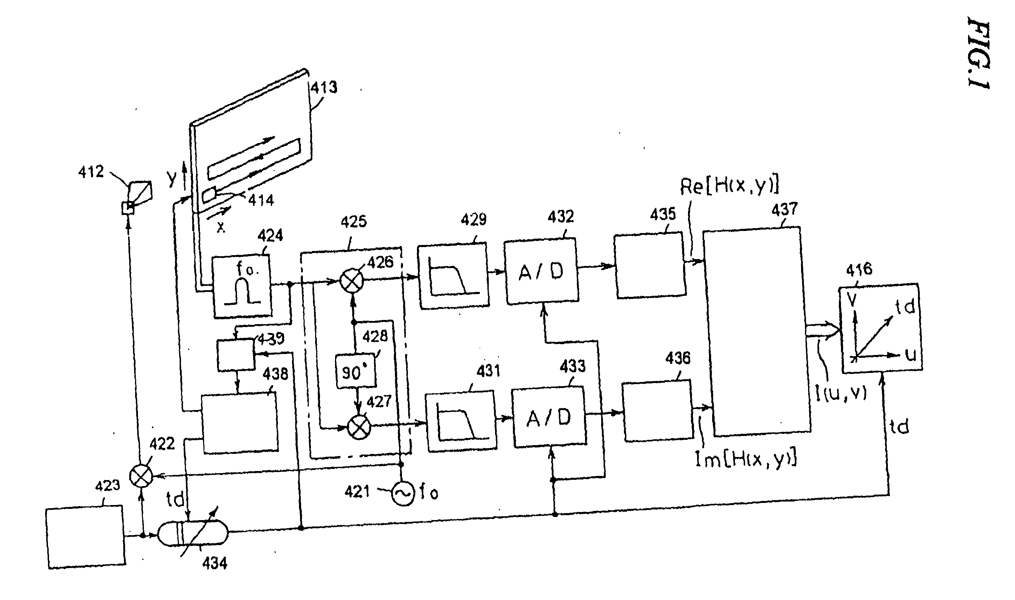

The present invention is explained below referring to Figs.1 to 3.
A first preferred embodiment of holographic radar according to the present invention is illustrated in Fig.1 (this embodiment is the subject of claim 1). In the following description the same reference numerals will be used for parts which correspond to those of Fig. 4. An oscillator 421 produces a high frequency sine wave at frequency $f_0$ which, in this embodiment, is modulated in modulator 422 by a pulse from a pulse generator 423. Each pulse of the modulated high frequency signal is supplied to an antenna 412 to be radiated in order to electromagnetically illuminate an observation space. Waves reflected from objects in the observation space are received by scanning-antenna receiving means 414 in a hologram observation plane 413.
A high frequency component $f_0$ of the signal received by the antenna means 414 is selected by a band pass filter 424 and a unit 425 performs quadrature detection using the high frequency signal $f_0$ from the oscillator 421. That is, the output from the filter 424 is supplied to two multipliers 426, 427 and is there multiplied by the high frequency signal from the oscillator 421, and that high frequency signal phase-shifted by $\pi/2$ by a phase shifter 428, respectively. An unnecessary component of each of the two signals output from the quadrature detector 425 is eliminated by a respective low pass filter 429, 431 before the signals are passed to respective analog-to-digital (A/D) converters 432, 433. In the A/D converters 432, 433 the signals are sampled in synchronism with pulses from pulse generator 423, the precise timing of the sampling being controlled by a delay means 434 implementing a variable time delay $t_d$. Hologram reconstruction calculations of the observation plane are performed on the sampled signal. If necessary, addition averaging is performed on the digital signals produced by the A/D converters 432, 433 and the signal to noise ratio is improved. A plurality of signals relating to the same receive point (x,y) are respectively supplied to hologram reconstruction calculation unit 437 via averaging circuits 435, 436. Hologram reconstruction calculations of the observation plane 413 are performed on signals Re[H(x,y)] and Im[H(x,y)] produced, for all of the plurality of observation points (x, y) in the hologram observation plane 413, using a particular time delay $t_{dn}$ in the sampling process, according to the following equation:

$$I(u,v) = \int \int H(x,y) \exp\{-j2\pi (ux + vy)\} \, dx \, dy \qquad (2)$$

Delay time $t_d$ corresponds to the distance r from the observation plane, that is, $r = c \cdot t_d/2$ (c being the speed of light).
The results I(u,v) obtained by hologram reconstruction unit 437 in respect of a particular distance r from the observation plane (particular delay time $t_{dn}$ used in the sampling) are displayed on a three-dimensional display unit 416. This display unit may be of the kind disclosed in "Visual Cues: Practical Data Visualisation" by Peter R. Keller and Mary M. Keller (IEEE Press, 1993). The images of reflecting bodies at different distances r from the observation plane may be obtained by repeating the signal gathering operation but changing the delay time $t_d$ used in the sampling.
The above-described embodiment is not limited to the case where a given value $t_{dn}$ of the delay is set and signals are then gathered from all observation points (x,y) on the observation plane 413. It is equally possible to select a particular location $(x_n, y_n)$ on the observation plane 413 and successively change the time delay $t_d$ used in sampling the received signal before moving on to process signals from a different location on the observation plane 413. Receive antenna 414 may be a high-speed switching array in which the interval between switching on of successive antennas in the array is equal to the minimum change in value of delay time $t_d$ so that for each high frequency pulse signals are received at each of the different antennas at different delay time $t_d$. When the following high frequency pulse is transmitted then there is a change in the position of the first antenna to be activated. Thus, signals may be gathered for each observation point (x,y) at each delay time $t_d$.

Signals for the full set of delay times $t_d$ need not be obtained from all of the points (x,y) on the observation plane. That is, the delay time $t_d$ when only one antenna or 1 point on the observation plane 413 is in a receiving condition can be controlled for each point (x,y) successively. The delay time $t_d$ of variable delay circuit 434 can be controlled by a control unit 438, provided also to switchably control which observation point (x,y) on the observation plane 413 has an antenna 414 in a receiving condition, which control unit receives as an input the output of band pass filter 424 via a gate 439 controlled by the output pulse of variable delay circuit 434. The control unit 438 decides, based on the presence of the received signal, whether only the switch control of $t_d$ is done or signals of all receive points are received

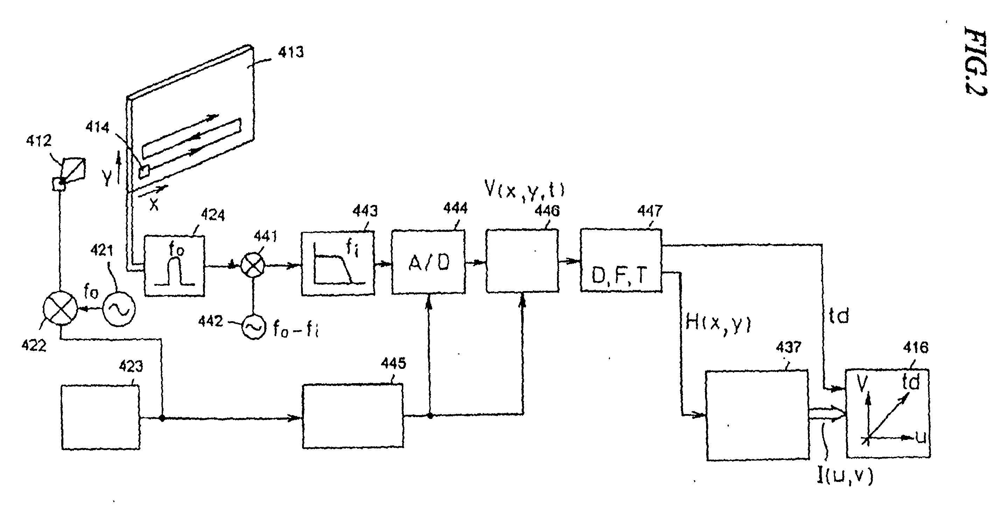

Next, a second embodiment of holographic radar according to the present invention will be described with reference to Fig.2 (this embodiment is the subject of claim 2). In Fig.2, the same reference numerals have been used for parts which are the same as in the embodiment of Fig.1.

In this embodiment of holographic radar, a local oscillator 442 outputs a signal at frequency $(f_0-f_i)$ which is mixed by a mixer 441 with the output of the band pass filter 424, and the mixer output is passed to a low pass filter 443. In this way, the signal at frequency $f_0$ output by the band pass filter 424 is converted to the low frequency $f_i$. For instance, $f_i$ may be about 1 MHz and $f_0$ may be from 1 to 10 GHz. The frequency-converted signal is sampled by an analog-to-digital converter 444, so as to produce a particularly faithful digital representation of the sampled signal, in accordance with a train of sampling pulses of a frequency which is two times higher than the low frequency signal. The sampling pulse train is produced by supplying pulses from pulse generator 423 to a pulse train generator 445.

The low frequency converted received signal is thus sampled by the above-mentioned pulse train at each observation point (x,y) of the observation plane 413 and the sampling output data V(x,y,t) is stored in a memory 446. A fixed number of samples of the sampling output data V(x,y,t) for each observation point (x,y) is read out of memory 446 at a fixed time $t_d$ and subjected by a discrete Fourier transform (DFT) unit 447 to a discrete Fourier transform (DFT) according to the following equation:

$$H(x,y) = \int V(x,y,t) \exp (-j2\pi f_i) \, dt \qquad (3),$$

where the range of integration is from $t_d$ to $(t_d + \Delta t)$.

$t_d$ to $(t_d + \Delta t)$ includes the same delay times as the set of delay times used in the embodiment of Fig. 1 and $\Delta t$ is the time period which corresponds to the number of data used for the DFT of Fig.1, that is, (sampling period x number of data) = $\Delta t$.

Results H(x,y) of the DFT are input to a hologram reconstruction calculation unit 437 which performs calculations according to equation (2) above. The results I(u,v), and the corresponding delay times $t_d$, are displayed in three dimensions using a three-dimensional display 416.

A particular example of operation will now be described in relation to the embodiment of Fig.1. The azimuth angle and the elevation angle are assumed to be 90° so as to define a segment of space which it is to be viewed from the observation plane and the distances are assumed to be 10m - 1000m. Observation resolution is assumed to be 1.5 degrees for the azimuth angle and for the elevation angle and 3m for distance. In this example, the distances between observation points are taken to be $\Delta x = \Delta y = 1.5$ cm If the number of observation points is 64 x 64 then an area of the observation plane becomes 1m x 1m. The frequency of the electromagnetic radiation used for illuminating the observation space is assumed to be $f_0 = 10$ GHz. The width of pulses generated by the pulse width generator 423 is assumed to be PW = 10 ns. Pulse repetition period is assumed to be $\tau = 10$ $\mu$s. The observation time covering all distances becomes 15 seconds. The scanning time within each distance from the observation plane become 50 ms if antenna 414 is made a scanning antenna and scanned electrically at each pulse repetition.

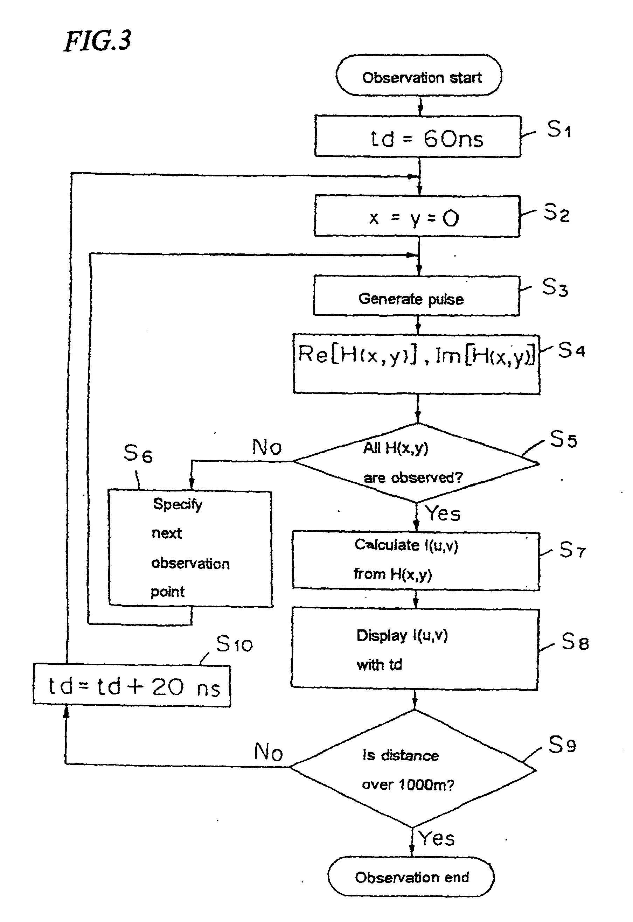

The processing procedure is as illustrated by Fig.3. First, delay time $t_d$ is set to 60 ns (S1). Measurement Point (x,y) on the observation plane 413 is assumed to be (x=0,y=0) (S2). A pulse is generated by pulse generator 423 (S3). Each output of the averaging circuits 435, 436 is memorized once in hologram reconstruction operation part 437 (S4). Next, it is checked whether or not data H(x,y) of all observation points has been acquired (S5). If data is still to be acquired from further observation points then the value of x or y is changed by $\Delta x$ or $\Delta y$, respectively, (S6), and the process returns to step S3. When data H(x,y) of all observation points has been acquired the hologram reconstruction calculation is performed (S7). The resulting data I(u,v) is displayed on display unit 416 in respect of a distance corresponding to $t_d$ [distance = $ct_d/2$] (S8). Next it is checked whether or not $t_d$ has attained a value corresponding to the maximum distance 1000m, that is whether $t_d$ has exceeded 6.7 $\mu$s (S9). If $t_d$ has not exceeded this value then the value of $t_d$ is increased by 20 ns (S10) and the process returns to step S2. When $t_d > 6.7$ $\mu$s, the observation is ended.

According to the present invention as described above, the number of calculations required are reduced, because signals are received from each distance from the observation plane and are subjected to hologram reconstruction equations using double integration according to the above equation (2). Moreover, the distance information for the received signals can readily be known from the delay time $t_d$ or range $t_d$ of the time of data row for the discrete Fourier transform by $t_d{}^+ \Delta t$.

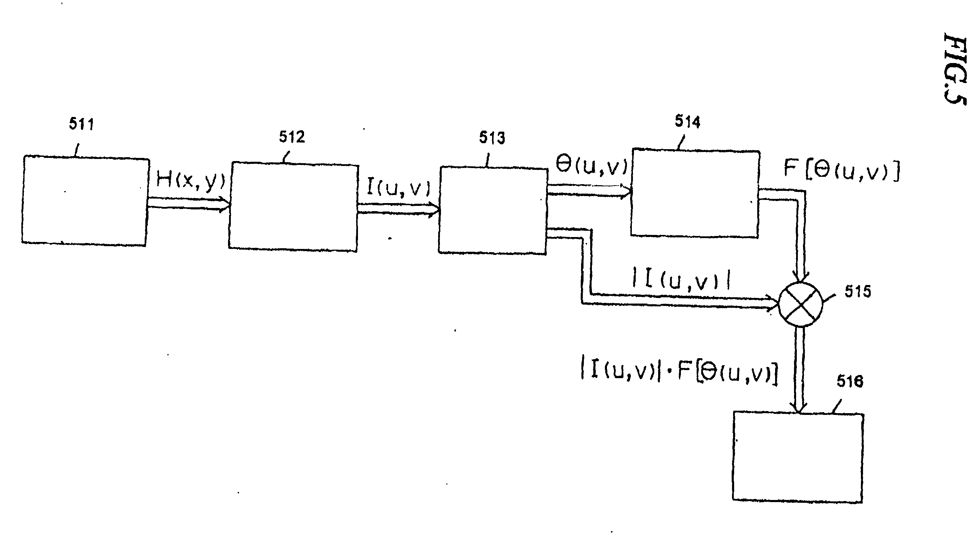

Fig.5 shows a display apparatus for complex wave information which may be used to display data obtained using the holographic radar of the present invention. Two-dimensional interference data H(x,y) regarding electromagnetic waves in three-dimensional space is obtained from interference data observation means 511. In this example, positions (x,y) in the observation plane are designated using an orthogonal co-ordinate system. Examples of possible constructions of the interference data observation means 511 are given later on. A hologram reconstruction unit 512 performs hologram reconstruction calculations using the two-dimensional interference data H(x,y). The Fraunhofer transform is used in the hologram reconstruction calculations, according to the following equation:

$$I(u,v) = \int \int H(x,y) \exp\{-2j\pi\ (ux+vy)\}\ dx\ dy \tag{4},$$

where u and v are the azimuth angle and the elevation angle, respectively; when viewed from point (x,y) on the observation plane. For instance, at observation points (x,y) on the observation plane spaced apart from the electromagnetic wave source by a distance Z, two-dimensional interference data H(x,y) are observed which represent the data from the source subjected to the transfer function of $\exp\{(j\pi/\lambda Z)(x^2+y^2)\}$. If hologram reconstruction calculations are performed on this two-dimensional interference data H(x,y) the above propagation function becomes $j\lambda Z \exp\{-j\pi\lambda Z (u^2+v^2)\}$. In addition, the Fourier integral of the observation plane is convolved into this.

A co-ordinate converter 513 converts the result of such hologram reconstruction calculations from orthogonal co-ordinates to polar co-ordinates I(u,v). That is, the real part and the imaginary part of I(u,v) is calculated. The amplitude and the phase of I(u,v) which corresponds to these real part and imaginary parts are also calculated. A hue converter 514 converts the phase information θ(u,v) of the co-ordinate-converted data into a colour signal F[θ(u,v)] of a corresponding hue. A multiplication unit 515 modulates the colour signal F[θ(u,v)] by multiplying it by the amplitude information |I(u,v)| of the coordinate-converted data from co-ordinate converter 513. The modulated output |I(u,v)|•F [θ(u,v)] is displayed on a colour display unit 516 as a colour image in the plane of u and v.

For an electromagnetic wave source which is close to the observation plane, the observed amplitude information |I(u,v)| of I(u,v) is large and drops off rapidly towards the periphery of the image corresponding to the source and the observed phase information θ(u,v) changes comparatively slowly while going from the center to the surrounding of the image corresponding to the source. On the other hand, for an electromagnetic wave source which is further away from the observation plane, the observed amplitude information of I(u,v) is small and weakens comparatively slowly while going from the center to the periphery of the image corresponding to the source and the observed phase information changes comparatively rapidly while going from the center to the surrounding of the image corresponding to the source.

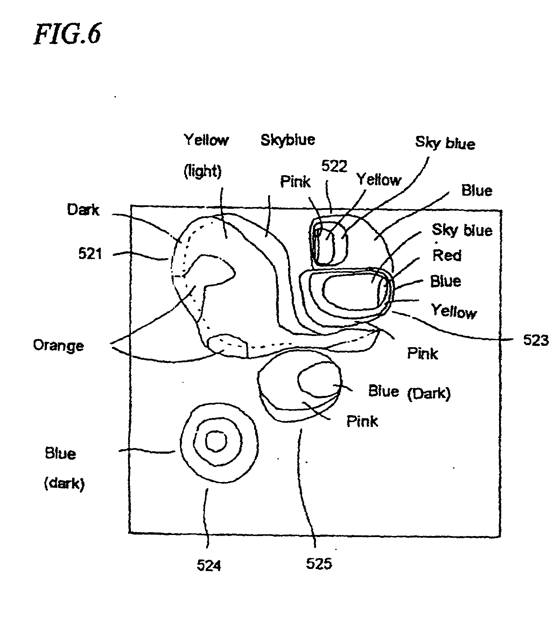

Fig.6 is an example of an image displayed on the display unit 516 when waste/leakage radiation from a piece of electronic equipment is observed at the observation plane by the apparatus of the invention, complex two-dimensional electromagnetic wave interference data is obtained and processing is performed as in the case of Fig.5. The large image 521 on the left upper part of the display is bright, with the brightness reducing rapidly towards the periphery of the image, and the stripes of colour in the image are wide meaning that the observed phase information changes comparatively slowly while going from the center to the surrounding of the image. Therefore, it is understood that image 521 is near the observation plane. Moreover, the colour stripes look wider on the left-hand side than on the right-hand side of image 521 and so an electromagnetic wave of this waste radiation is judged to radiate from the left as seen in the figures.

Image 522, to the right and slightly above image 521 on the image display, is smaller than image 521, has weak brightness and the colour striping is detailed. That is, the phase changes rapidly from the center of the image towards the edges and the striping at the right of the image is coarser than that at the left. That is, it is deduced that image 522 corresponds to a radiation source which is further away and to the right of that corresponding to image 521.

Image 523, between the lower right-hand portion of image 521 and image 522, is slightly larger and brighter than image 522 and the thickness of the colour stripe is about the same as for image 522. Therefore, the radiation source of image 521 is judged to be located at about the same distance as image 522 from the observation plane. However, image 523 corresponds to a slightly stronger source and, from the colour striping, it is understood that this source is radiating to the left because the colour stripes on the right-hand side are finer than those on the left-hand side.

Image 524 spaced apart from image 521 has light and dark portions, the maxilla of the colour stripes are only just fatter than that of the image 522. Therefore, it is judged to correspond to a weak radiation source at a distance which is the same or more than that of the images 522, 523 from the observation plane in the direction perpendicular to the observation plane.

Similarly, image 525, between image 521 and image 524, is judged to correspond to a weak radiation source, radiating to the left, which is comparatively near the observation plane.

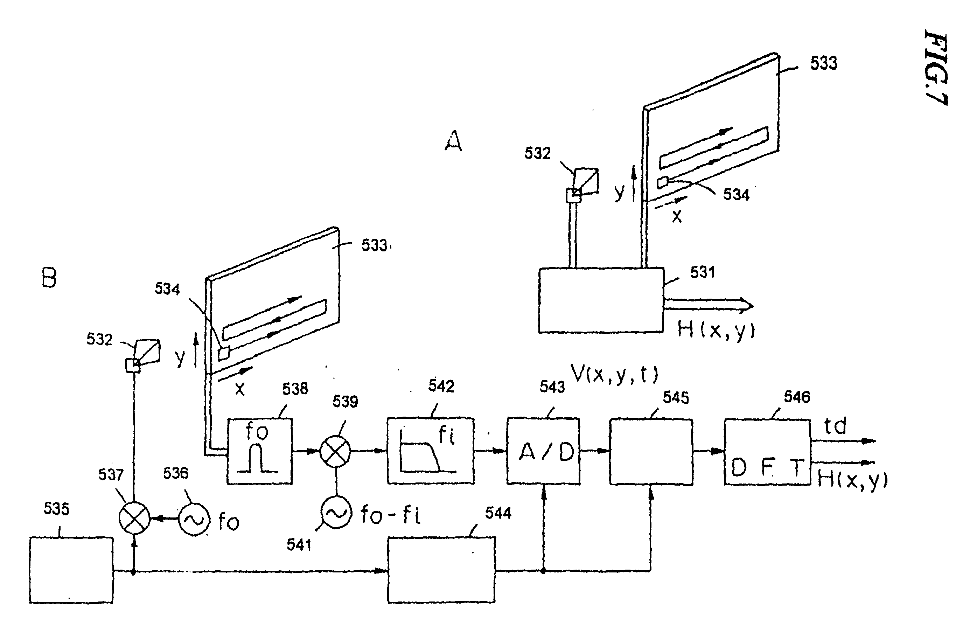

Next, a concrete example of the two-dimensional interference data observation means 511, as shown in Fig. 7, will be described.

Fig.7A is provided to aid understanding of the use of the display apparatus of Fig.5 for display of data obtained by holographic radar in general. In the case of the holographic radar of Fig.7A, a high frequency signal, such as a signal in the microwave or millimeter region, is supplied by network analyzer 531 to antenna 532 for illuminating the observation space with continuously radiated high frequency electromagnetic waves. The reflected waves (which usually are interference waves caused by interference between reflected waves from two or more places in the observation space) are received by receive antenna 534 at each point $(x,y)$ on a hologram observation plane 533 arranged to face the observation space, and the corresponding output is fed to network analyzer 531. An example of the transfer function of the signal path of an electromagnetic wave from the illuminating antenna 532 to a receive point $(x,y)$, that is, two-dimensional interference data $H(x,y,f)$ is given in "Near-Field Antenna Measurement" by, Dan Slater (Artech House 1991).

Receive antenna 534 may be moved to each observation point $(x,y)$ on the observation plane 533 so as sequentially to receive the reflected waves falling on the respective points $(x,y)$. Alternatively, a receiving antenna 534 may be provided at each observation point on the observation plane 533 and switched in turn so as to successively feed to network analyzer 531 signals received at each observation point $(x,y)$. That is, reflected waves falling on each observation point $(x,y)$ on the observation plane 533 are received by scanning-antenna receiving means. The frequency F of the illuminating high frequency electromagnetic waves is changed in small steps and the space transfer function, that is, the two-dimensional interference data $H(x,y,f)$, is measured at each frequency as mentioned above.

Another example is shown in Fig.7B in which the same reference numerals have been used for parts which correspond to those shown in Fig.7A. A signal of microwave frequency $f_0$ generated by an oscillator *536* is modulated by modulator 537 by a pulse signal from a pulse generator 535 and a resulting high frequency pulse is radiated from antenna 532. The corresponding signal received by antenna 534 is fed to a pass band filter 538 having center frequency $f_0$. The filter output is mixed by a mixer 539 with a local signal of frequency $(f_0-f_i)$ from a local oscillator 541. The mixer output is passed through a low-pass filter 542. Thus the signal of frequency $f_0$ from pass band filter 538 is converted to a signal of low frequency $f_i$. As an example, $f_0$ may be in the range 1GHz - 10 GHz and $f_i$ may be 1 MHz. The low frequency signal is sampled by an analog-to-digital converter 543 in synchronism with a pulse train of a frequency twice that of the low frequency signal and each sample is converted into a digital value. The sampling pulse train is generated by a pulse train generator 544 which receives as an input pulses from pulse generator 535.

The low-frequency-converted received signal for each received point $(x,y)$ on the observation plane is thus sampled by the above-mentioned pulse train and the digital sample values $V(x,y,t)$ are stored in a memory 545. A discrete Fourier transform unit 546 performs a discrete Fourier transform on a block of data $V(x,y,t)$ corresponding to a fixed time period $t_d$ read out from memory 545 for a respective receive point $(x,y)$, according to the following equation:

$$H(x,y) = \int V(x,y,t) \exp(-j2\pi f_i) \, dt \qquad (5)$$

The range of the integration here is taken to be $t_d$ to $t_d+\Delta t$.

The thus-obtained results of the Fourier transform are two-dimensional interference data $H(x,y)$ and $t_d$ corresponds to the distance Z from the observation plane 533.

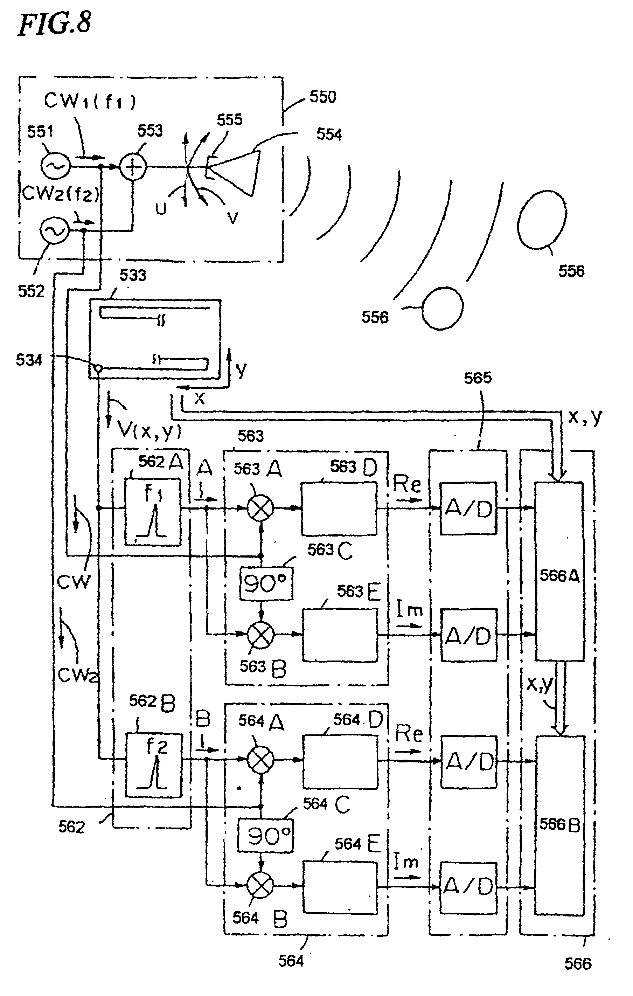

Another example of two-dimensional interference data observation apparatus useable with the image display apparatus of Fig. 5 is shown in Fig.8. Continuous wave signals $CW_1,CW_2$ of two frequencies $f_1$, $f_2$ which are close together, produced by sources 551, 552, are combined by an adder 553 and fed to a radiation transducer 554 which radiates in a single direction defined by azimuth and elevation angles u, v. A driving means 555 displaces the radiation transducer 554 so as to vary the azimuth and elevation angles of the radiated beam in an oscillating manner. Elements 551 to 555 are considered to make up an oscillating signal oscillator 550. The frequencies of the signals output by the sources 551, 552 may be $f_1$ = 15.003 GHZ and $f_2$ = 15.009 GHz.

A receiving transducer 534 may be composed of an antenna for receiving electromagnetic waves reflecting from an observation object 556 and may be displaced in directions x,y on an observation plane 535 (hereafter termed "hologram observation plane") facing the observation object 556, so as to scan the observation plane. Whenever radiating transducer 554 performs one sweep of the radiated beam, receiving antenna 534 executes one scan of the hologram observation plane. The hologram data is generated evenly from the whole area of observation object 556 repeatedly from about two to four times.

A frequency selection means 562 separates the hologram received signal $V(x,y)$ received by transducer 534 into a signal A of frequency $f_1$ and a signal B of frequency $f_2$. In this example, frequency selection means 562 is shown as consisting of band pass filters *562A* and 562B. Signals A and B separated by frequency selection means 562 are input into respective first Fourier integral means 563, 564. Each of the first Fourier integral means 563, 564 may be composed of a pair of mixers 563A, 563B (564A, 564B), a pair of low pass filters 563D 563E (564D, 564E) and a phaser 563C (564C) which is used to shift the phase of the respective reference signals $CW_1$ ($CW_2$) by 90° and input the phase-shifted signal to the mixers 563B (564B). The mixers 563A, 563B, 564A, 564B output sum and difference frequencies. In this example, the respective difference frequencies are selected by the low-pass filters 563D, 563E, 564D and 564E. That is, a beat signal is extracted by each of the low pass filters 563D, 563E, 564D and 564E. The real part Re, of the quadrature component of hologram data at each observation point (x,y) is obtained by the mixers 563A, 564A which multiply their respective inputs by the respective reference signals $CW_1$, $CW_2$. Furthermore, the imaginary part, Im, of the quadrature component of hologram observation data at each observation point (x,y) is obtained by mixers 563B, 564B.

The real and imaginary component signals, Re and Im, are fed to analog-to-digital conversion unit 565 and the converted output is supplied to a second Fourier integral means 566. It is possible to provide each of the memories 566A and 566B of the second Fourier integral means 566 as a pair of memories. In such a case, since respective real Re and imaginary Im component signals form pairs it is preferable to store corresponding Re and Im signals at the same addresses in the respective memories making up memories 566A or 566B.

A position signal (x,y) representing the scanning position of the receiving transducer 534 can be fed to the second Fourier integral means 566 to serve as an address for storing the corresponding orthogonal component signals Re, Im. The orthogonal components (real number part Re and imaginary number part Im) concerning each observation point (x,y) stored in the second Fourier integral means 566 can be accessed to obtain two-dimensional interference data $H(x,y,f_1)$ and $H(x,y,f_2)$. Hologram reconstruction calculations are performed on the two-dimensional interference data $H(x,y,f_1)$, $H(x,y,f_2)$ by hologram reconstruction calculation unit 512 of the image display apparatus shown in Fig. 5, according to the following equations:

$$I(u,v,f_1) = \int \int H(x,y,f_1) \exp\{-2j\pi (ux+vy)\} \, dx \, dy$$

$$I(u,v,f_2) = \int \int H(x,y,f_2) \exp\{-2j\pi (ux+vy)\} \, dx \, dy \tag{6}.$$

The sum $|I(u,v)|$ of amplitude information of the results of these reproduction calculations and the difference $\theta(u,v)$ of phase information are calculated by co-ordinate converter 513 according to the following equations:

$$|I(u,v)| = |I(u,v,f_1)| + |I(u,v,f_2)|$$

$$\theta(u,v) = \theta(u,v,f_1) - \theta(u,v,f_2) \tag{7}.$$

The latter signal is supplied to the hue converter 514 and the former signal is supplied to multiplication unit 515.

With the display apparatus of Fig.5, complex two-dimensional wave interference data can be displayed in a manner giving a feeling of distance in a direction at a right angle to the observation plane by converting the phase information into a hue signal and modulating the hue signal by amplitude information. That is, complex three-dimensional space can be displayed using two-dimensional computer graphics.

It is to be understood that the data calculated by apparatus according to the invention can be outputted in some manner other than image display discussed above. Thus, for example, the data can be output to a printer for printing in any desired form including, but not limited to, an image representation, numerical data, a graph or chart, etc.; to a memory device; to a further data processing device; etc.

**Claims**

1. A holographic radar comprising:

   means (412) for radiating electromagnetic waves generated from a high frequency signal modulated by a pulse signal;
   scanning-antenna receiving means (414) for receiving reflected waves at a number of observation points on a hologram observation plane (413) and for outputting received signals;

means (425) for quadrature-detecting said received signals using said high frequency signal;

means (432,433) for sampling said quadrature-detected signals by a sampling pulse signal synchronized with said pulse signal;

means (437) for performing hologram reconstruction calculations over said hologram observation plane to said sampled signal;

variable delay means (434) for delaying said sampling pulse signal by a delay value; and

display means (416) for displaying results of said hologram reconstruction calculations and said delay value in three dimensions.

2. A holographic radar comprising:

means (412) for radiating electromagnetic waves generated from a high frequency signal modulated by a pulse signal;

scanning-antenna receiving means (414) for receiving reflected waves at a number of observation points on a hologram observation plane and for outputting received signals;

means (441-443) for converting said received signals to low frequency signals;

means (444) for sampling said low frequency signals at a frequency two times or more than two times higher than the frequency of said low frequency signals, synchronized with said pulse signal;

means (447) for converting a fixed number of data of said sampled outputs which are delayed for specified delay value, using the discrete Fourier transform;

means (437) for performing hologram reconstruction calculations over said observation plane on results of the discrete Fourier transform; and

display means (416) for displaying results of said hologram reconstruction calculations and said delay value in three dimensions.

3. A holographic radar according to claim 1 which further comprises means (438) for judging whether said received signals at the advent of said sampling pulse signal from said variable delay means, and means for obtaining said received signals at all of said observation points only when the judgement is true.

4. A holographic radar according to claims 1 to 3 wherein said scanning-antenna receiving means (414) is composed of an array antenna on said observation plane and received signals of said array antenna are output by electrically scanning said array antenna.

5. A holographic radar according to claims 1 to 3 wherein said scanning-antenna receiving means (414) is composed of a scanning antenna which is moved to specified positions on said observation plane, and received signals of said scanning antenna are output at specified positions.

**Patentansprüche**

1. Holographisches Radarsystem mit:

- Mitteln (412) zur Ausstrahlung elektromagnetischer Wellen, die von einem durch ein Impulssignal moduliertes Hochfrequenzsignal erzeugt werden;
- einer Abtastantennenempfangseinrichtung (414) für den Empfang reflektierter Wellen an mehreren Beobachtungspunkten auf einer Hologramm-Beobachtungsebene (413) und zur Ausgabe der empfangenen Signale;
- Mitteln (425) zur Quadratur-Erfassung dieser empfangenen Signale unter Verwendung des Hochfrequenzsignals;
- Mitteln (432, 433) zum Abtasten der Quadratur-erfaßten Signale durch ein Tastimpulssignal, das mit dem Impulssignal synchronisiert ist;
- Mitteln (437) zur Durchführung von Hologramm-Rekonstruktionsberechnungen über der Hologramm-Beobachtungsebene am getasteten Signal;
- variablen Verzögerungsmitteln (434) zur Verzögerung des Tastimpulssignals durch einen Verzögerungswert; und
- Anzeigemitteln (416) zur Anzeige der Ergebnisse der Hologramm-Rekonstruktionsberechnungen und des Verzögerungswerts in drei Dimensionen.

2. Holographisches Radarsystem mit:

- Mitteln (412) zur Ausstrahlung elektromagnetischer Wellen, die von einem durch ein Impulssignal moduliertes Hochfrequenzsignal erzeugt werden;
- einer Abtastantennenempfangseinrichtung (414) für den Empfang reflektierter Wellen an mehreren Beobachtungspunkten auf einer Hologramm-Beobachtungsebene (413) und zur Ausgabe der empfangenen Signale;
- Mitteln (441-443) zur Umwandlung der empfangenen Signale in Niederfrequenzsignale;
- Mitteln (444) zum Abtasten der Niederfrequenzsignale bei einer Frequenz, die doppelt so hoch oder mehr als doppelt so hoch ist wie die Frequenz der Niederfrequenzsignale, synchronisiert mit dem Impulssignal;
- Mitteln (447) zur Umwandlung einer festen Anzahl von Daten der getasteten Ausgangssignale, die um einen spezifizierten Verzögerungswert verzögert sind, unter Verwendung der diskreten Fourier-Transformation;
- Mitteln (437) zur Durchführung von Hologramm-Rekonstruktionsberechnungen an den Ergebnissen der diskreten Fourier-Transformation; und
- Anzeigemitteln (416) zur Anzeige der Ergebnisse der Hologramm-Rekonstruktionsberechnungen und des Verzögerungswerts in drei Dimensionen.

3. Holographisches Radarsystem nach Anspruch 1, das weiter Mittel (438) aufweist, um zu beurteilen, ob die empfangenen Signale bei Ankunft des Tastimpulssignals von den variablen Verzögerungsmitteln erhalten werden sollen, und Mittel, um die empfangenen Signale an allen Beobachtungspunkten nur dann zu erhalten, wenn die Beurteilung richtig ist.

4. Holographisches Radarsystem nach den Ansprüchen 1 bis 3, bei dem die Abtastantennenempfangseinrichtung (414) aus einer Array-Antenne auf der Beobachtungsebene besteht und die von der Array-Antenne empfangenen Signale durch elektrisches Abtasten der Array-Antenne ausgegeben werden.

5. Holographisches Radarsystem nach den Ansprüchen 1 bis 3, bei dem die Abtastantennenempfangseinrichtung (414) aus einer Abtastantenne besteht, die zu spezifizierten Positionen der Beobachtungsebene bewegt wird, und von der Abtastantenne empfangene Signale werden an spezifizierten Positionen ausgegeben.

**Revendications**

1. Radar holographique comprenant :

   un moyen (412) destiné à faire rayonner des ondes électromagnétiques générées à partir d'un signal à haute fréquence modulé par un signal d'impulsion,
   un moyen de réception à antenne à balayage (414) destiné à recevoir des ondes réfléchies en un certain nombre de points d'observation sur un plan d'observation d'hologramme (413) et destiné à fournir en sortie des signaux reçus,
   un moyen (425) destiné à détecter en quadrature lesdits signaux reçus en utilisant ledit signal à haute fréquence,
   un moyen (432, 433) destiné à échantillonner lesdits signaux détectés en quadrature par un signal d'impulsion d'échantillonnage synchronisé avec ledit signal d'impulsion,
   un moyen (437) destiné à exécuter des calculs de reconstitution d'hologramme sur ledit plan d'observation d'hologramme pour ledit signal échantillonné,
   un moyen de retard variable (434) destiné à retarder ledit signal d'impulsion d'échantillonnage d'une valeur de retard, et
   un moyen d'affichage (416) destiné à afficher des résultats desdits calculs de reconstitution d'hologramme et ladite valeur de retard dans les trois dimensions.

2. Radar holographique comprenant :

   un moyen (412) destiné à faire rayonner des ondes électromagnétiques générées à partir d'un signal à haute fréquence modulé par un signal d'impulsion,
   un moyen de réception à antenne à balayage (414) destiné à recevoir des ondes réfléchies en un certain nombre de points d'observation sur un plan d'observation d'hologramme et destiné à fournir en sortie des signaux reçus,
   un moyen (441 à 443) destiné à convertir lesdits signaux reçus en signaux à basse fréquence,
   un moyen (444) destiné à échantillonner lesdits signaux à basse fréquence à une fréquence deux fois, ou plus de deux fois, plus élevée que la fréquence desdits signaux à basse fréquence, synchronisés avec ledit signal d'impulsion,

un moyen (447) destiné à convertir un nombre fixe de données desdites sorties échantillonnées qui sont retardées pendant une valeur de retard spécifiée, en utilisant la transformation de Fourier discrète,

un moyen (437) destiné à exécuter des calculs de reconstitution d'hologramme sur ledit plan d'observation sur des résultats de la transformation de Fourier discrète, et

un moyen d'affichage (416) destiné à afficher des résultats desdits calculs de reconstitution d'hologramme et ladite valeur de retard dans les trois dimensions.

3. Radar holographique selon la revendication 1, qui comprend en outre un moyen (438) destiné à évaluer s'il faut obtenir lesdits signaux reçus à l'occurrence dudit signal d'impulsion d'échantillonnage provenant dudit moyen à retard variable, et un moyen destiné à obtenir lesdits signaux reçus à tous lesdits points d'observation uniquement lorsque l'évaluation est vérifiée.

4. Radar holographique selon les revendications 1 à 3, dans lequel ledit moyen de réception à antenne à balayage (414) est composé d'une antenne en réseau sur ledit plan d'observation et les signaux reçus de ladite antenne en réseau sont alors fournis en sortie par un balayage avec ladite antenne en réseau.

5. Radar holographique selon les revendications 1 à 3, dans lequel ledit moyen de réception à antenne à balayage (414) est composé d'une antenne à balayage qui est déplacée vers des positions spécifiées sur ledit plan d'observation, et des signaux reçus de ladite antenne à balayage sont fournis en sortie à des positions spécifiées.

# FIG.1

FIG.2

**FIG.3**

Observation start

$td = 60ns$ — $S_1$

$x = y = 0$ — $S_2$

Generate pulse — $S_3$

$Re[H(x,y)]$, $Im[H(x,y)]$ — $S_4$

$S_6$ — No — All $H(x,y)$ are observed? — $S_5$

Specify next observation point

Yes

Calculate $I(u,v)$ from $H(x,y)$ — $S_7$

Display $I(u,v)$ with td — $S_8$

$S_{10}$

$td = td + 20\ ns$

No — Is distance over 1000m? — $S_9$

Yes

Observation end

**FIG.4**

*FIG.5*

# FIG.6

*FIG.7*

## FIG.8